# EUROPÄISCHE PATENTSCHRIFT

(11) **EP 0 566 921 B1**
(45) Veröffentlichungstag und Bekanntmachung des Hinweises auf die Patenterteilung: **13.11.1996**
(21) Anmeldenummer: 93105589.1
(22) Anmeldetag: 05.04.1993
(51) Int. Cl.: H01L 23/552, H01L 23/495

(54) **Halbleiterbaugruppe, insbesondere Fernsteuer-Empfangsmodul**
Semi-conductor assembly, in particular a remote control/receiver module
Assemblage à semi-conducteurs, en particulier un module télécommande-récepteur

(30) Priorität: 18.04.1992 DE 4212948
(43) Veröffentlichungstag der Anmeldung: 27.10.1993
(73) Patentinhaber: TEMIC TELEFUNKEN microelectronic GmbH, 74072 Heilbronn (DE)
(72) Erfinder: Angerstein, Jörg, Dr., W-7101 Flein (DE); Schairer, Werner, Dr., W-7102 Weinsberg (DE); Giebler, Siegfried, W-7156 Wüstenrot-Neuhütten (DE); Scheidle, Helmut, W-7106 Neuenstadt (DE); Mistele, Thomas, W-7129 Ilsfeld (DE)
(74) Vertreter: Maute, Hans-Jürgen, Dipl.-Ing.

(56) Entgegenhaltungen:
- EP-A- 0 409 196
- EP-A- 0 465 084
- DE-A- 1 564 563
- DE-A- 4 031 051

## Beschreibung

### Technisches Gebiet

Die Erfindung betrifft eine Halbleiterbaugruppe, insbesondere einen Fernsteuer-Empfangsmodul.

### Stand der Technik

Die Hauptkomponenten einer Halbleiterbaugruppe sind ein Träger und Halbleiterbauteile, die auf dem Träger befestigt sind. Hinzu kommt noch ein Gehäuse, das in Form eines Vergusses ausgebildet sein kann.

Bei Halbleiterbaugruppen mit Bauteilen mit größerem Gesamtvolumen ist der Träger in der Regel eine Platine, die meistens aus einem mit Leiterbahnen versehenen Isolator besteht. Halbleiterbaugruppen mit Bauteilen mit kleinerem Gesamtvolumen weisen dagegen typischerweise einen Streifenaufbau auf, bei dem mindestens ein Halbleiterbauteil an leitenden Streifen befestigt ist, zu denen ein Masse-Streifenteil gehört. Das Gehäuse beim Streifenaufbau wird grundsätzlich durch einen Verguß gebildet. Eine Halbleiterbaugruppe mit Streifenaufbau weist damit folgende Teile auf:
- ein mit Masse zu verbindendes Masse-Streifenteil als eines von mindestens zwei Streifenteilen;
- mindestens ein Halbleiterbauteil, das auf dem Masse-Streifenteil in dessen oberem Bereich auf einem Trägerabschnitt des Masse-Streifenteils befestigt ist; und
- einen den oberen Bereich der Streifenteile einschließenden Verguß.

Die von der Firma Telefunken electronic im Datenblatt ,,selection Guide Transistors and Diodes", Edition 1990/91 auf Seiten 19 und 23 angebotenen Dioden und Transistoren mit einem TO 202-Gehäuse weisen einen Streifenaufbau mit einem Masse-Streifenteil auf, in dessen mittleren Bereich auf einem Trägerabschnitt ein Halbleiterbauteil befestigt ist. Das Masse-Streifenteil ist mit einem Verlängerungsabschnitt über den Trägerabschnitt hinaus verlängert. Der mittlere Bereich der Streifenteile ist von einem Verguß eingeschlossen. Der Verlängerungsabschnitt dient bei den bekannten Bauteilen als Kühlfahne zur Befestigung an einem Kühlkörper. Zu diesem Zweck kann die Kühlfahne nach Bedarf gebogen sein.

In der EP-A-0 409 196 ist eine Halbleiterbaugruppe mit Streifenaufbau beschrieben, die in ein Plastikgehäuse vergossen wird und bei der durch Biegen die Trägerabschnitte für die Halbleiterchips abgesenkt sind. Die Idee, die Streifenteile nicht nur für die Zuleitungen zu biegen, ist dadurch bekannt.

Aus der DE-A-1 564 563 ist es bekannt, die streifenförmigen Zuleitungen eines auf einem Trägerabschnitt montierten Halbleiterbauelements durch Biegen zu formen und eine der Zuleitungen zur Abschirmung einzusetzen.

Bei zahlreichen Halbleiterbaugruppen ist es erforderlich, mindestens eines der Halbleiterbauteile, die es enthält, gegen elektromagnetische Störstrahlung abzuschirmen. Dies gilt vor allem für alle Arten von Detektoren für elektromagnetische Strahlung. Halbleiterbaugruppen mit Abschirmung weisen typischerweise den vorstehend genannten Aufbau mit einer Trägerplatine auf, an der sich die Abschirmung gut befestigen läßt. Letztere besteht z. B. aus einem Gehäuse aus einem elektrisch leitenden Kunststoff, aus Blech oder aus einem Drahtgitter.

Auch eine optische Abschirmung ist erforderlich. Fernsteuer-Empfangsmodule, wie sie z. B. in Fernsehgeräten verwendet werden, empfangen modulierte IR-Strahlung, die von Halbleiterdioden ausgesendet wird, in einem Wellenlängenbereich, in dem auch Störstrahler, wie z. B. Glühlampen, Leuchtstoffröhren oder Energiesparlampen Infrarotstrahlung emittieren. Als Detektor im Empfangsmodul wird typischerweise eine Si-pin-Diode verwendet, die Strahlung bis etwa 1100 nm absorbiert. zur kurzwelligen Seite hin wird Störstrahlung durch ein Kantenfilter ausgefiltert, dessen Absorptionskante bei z. B. etwa 800 nm liegt. Die Absorptionskante des Filters kann leicht durch Wahl eines entsprechenden Farbstoffs eingestellt werden. Der Farbstoff wird in der Regel in das Vergußmaterial gemischt. Das Filter muß sich mindestens im Bereich zwischen einer Öffnung in der elektromagnetischen Abschirmung und der Detektorfläche befinden. Um zu verhindern, daß in die genannte Öffnung in der Abschirmung elektromagnetische Störstrahlung eintritt, werden verschiedene Maßnahmen ergriffen. Eine besteht darin, die Öffnung mit einer für die zu empfangende Strahlung durchsichtigen, elektrisch leitenden Folie zu verschließen. Eine andere Maßnahme ist die, ein Lochblech oder Drahtgitter in der Öffnung anzubringen. Eine dritte Maßnahme besteht darin, den Detektor mit einer Vorderseitenkontaktierung zu versehen, die mit Masse verbunden wird.

Die bekannten Halbleiterbaugruppen mit mindestens einem gegen elektromagnetische Strahlung abzuschirmenden Halbleiterbauteil sind wegen der gesondert zu montierenden Abschirmung platzaufwendig und teuer in der Herstellung. Sie erfordern auch eine zuverlässig wirkende elektrische Verbindung zwischen der Abschirmung und einem Masseanschluß.

Es bestand demgemäß das Problem, eine Halbleiterbaugruppe mit mindestens einem elektromagnetisch abgeschirmten Halbleiterbauteil anzugeben, die kompakt baut, billig herstellbar ist und einen zuverlässigen Masseanschluß der Abschirmung gewährleistet.

### Darstellung der Erfindung

Die erfindungsgemäße Halbleiterbaugruppe ist eine solche mit einem Streifenaufbau, wie er eingangs beschrieben wurde. Diese Baugruppe ist dadurch gekennzeichnet, daß das Masse-Streifenteil einen Verlängerungsabschnitt aufweist, mit dem es über den Trägerabschnitt hinaus verlängert ist, und der gegenüber dem Trägerabschnitt so umgeklappt ist und eine solche Länge aufweist, daß er das Halbleiterbauteil überdeckt, um dieses elektromagnetisch abzuschirmen.

Im Gegensatz zu den bisher typischerweise verwendeten Halbleiterbaugruppen mit elektromagnetisch abgeschirmtem Halbleiterbauteil ist die erfindungsgemäße Baugruppe keine mit Platinenaufbau, sondern eine solche mit Streifenaufbau, was allerdings für sich noch nicht zu einem großen Vorteil führt, da es im Montageaufwand kein großer Unterschied ist, ob ein Platinenaufbau oder ein Streifenaufbau mit einem elektromagnetisch abschirmenden Gehäuse verbunden wird. Wesentliche Vorteile weist die erfindungsgemäße Halbleiterbaugruppe dadurch auf, daß das Masse-Streifenteil so ausgestaltet ist, daß es nicht nur zum Tragen mindestens eines Halbleiterbauteils und zum Herstellen mindestens eines Massekontaktes dient, sondern daß es zugleich die Funktion einer elektromagnetischen Abschirmung aufweist. Diese Abschirmung ist ganz offensichtlich zuverlässig mit Masse verbunden, da sie ja Teil des Massekontaktes selbst ist. Diese Abschirmung ist auch einfach montierbar, da keinerlei mechanische Schritte zum Verbinden mit anderen Bauteilen erforderlich sind, sondern da lediglich das Masse-Streifenbauteil so umzuklappen ist, daß es das mindestens eine in seinem Trägerabschnitt befestigte Halbleiterbauteil überdeckt. Dadurch, daß keine besonderen mechanischen Verbindungen, die in der Regel stabile Verbindungsstellen erfordern, herzustellen sind, ist der Raumbedarf sehr gering. Das durch die umgebogenen Abschnitte des Masse-Streifenteils hergestellte abschirmende Gehäuse mit seinen kleinen Abmessungen ist zunächst sehr instabil, wird jedoch durch den Verguß stabil und beschädigungsgeschützt in seiner Form gehalten.

Wenn das elektromagnetische abgeschirmte Halbleiterbauteil ein Strahlungsdetektor ist, muß der umgeklappte Verlängerungsabschnitt eine Aussparung aufweisen, durch die die zu detektierende Strahlung eindringen kann. Damit trotzdem elektromagnetische Strahlung möglichst gut abgeschirmt wird, kann diese Öffnung z. B. so aus dem Masse-Streifenteil gestanzt werden, daß noch Stege in Form eines Gitters zurückbleiben, oder eine ganz ausgestanzte Öffnung kann mit einer für sich bekannten elektrisch leitenden durchsichtigen Folie abgedeckt werden. Von besonderem Vorteil ist es, einen Detektor mit einer Vorderseitenkontaktierung zu verwenden und diese mit dem Masse-Streifenteil zu verbinden. Außerdem trägt es zur Qualität der Abschirmung erheblich bei, wenn das Halbleiterbauteil in eine Vertiefung im Trägerabschnitt eingesetzt ist.

Wird die Erfindung auf einen Fernsteuer-Empfangsmodul angewandt, ergibt sich eine Verringerung des Raumbedarfs auf etwa ein Fünftel im Vergleich zu den bisher kleinsten Aufbauten, bei denen der Träger und die Abschirmung nicht einstückig als Streifenteil ausgebildet sind, sondern bei denen diese beiden Teile jeweils getrennt der Fertigung zugeführt werden und erst während des Herstellvorgangs des Moduls mechanisch und elektrisch miteinander verbunden werden.

### Zeichnung

Fig. 1: Draufsicht auf einen vereinfacht dargestellten Streifenaufbau mit einem Masse-Streifenteil mit mehreren Abschnitten, die noch alle in einer Ebene liegen;
Fig. 2: Längsschnitt durch den Streifenaufbau gemäß Fig. 1, wobei jedoch verschiedene Abschnitte des Masse-Streifenteils umgeklappt sind, um eine elektromagnetische Abschirmung für ein Halbleiterbauteil zu bilden;
Fig. 3: Draufsicht entsprechend der von Fig. 1, jedoch für ein konkretes Beispiel eines Streifenaufbaus für ein Fernsteuer-Empfangsmodul; und
Fig. 4: Detaildraufsicht auf den oberen Bereich des Streifenaufbaus in Fig. 3.

### Beschreibung von Ausführungsbeispielen

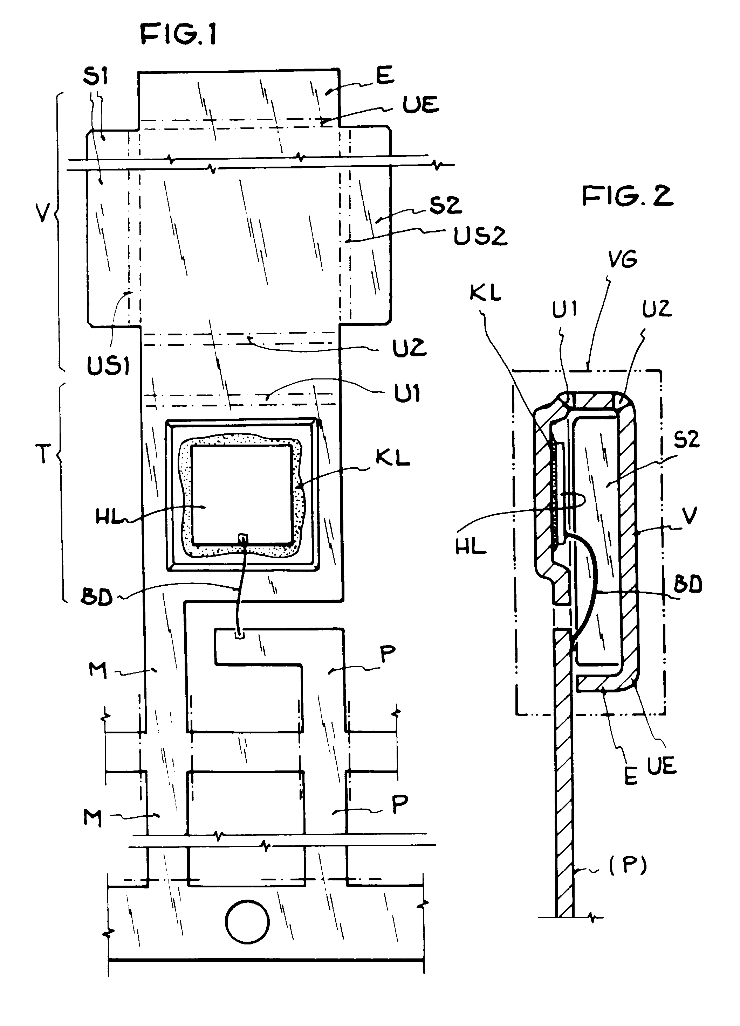

Die Fig. 1 und 2 veranschaulichen eine Halbleiterbaugruppe mit Streifenaufbau in einfachster Form. Fig. 1 veranschaulicht licht dabei einen Zustand, wie er während der Herstellung vorliegt, während Fig. 2 die fertiggestellte Baugruppe in einem Schnittbild illustriert.

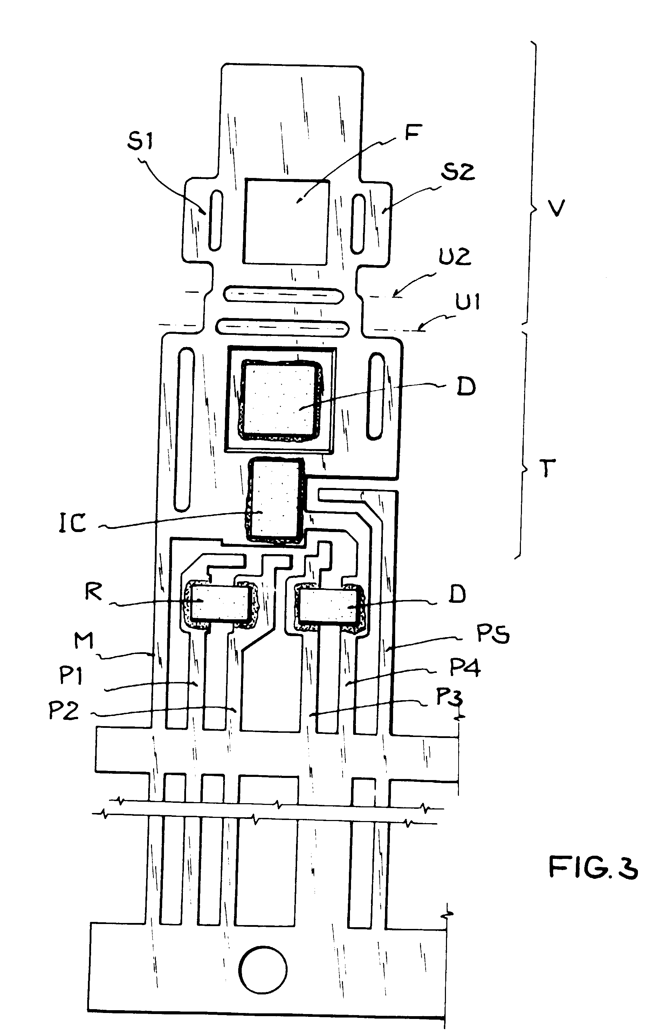

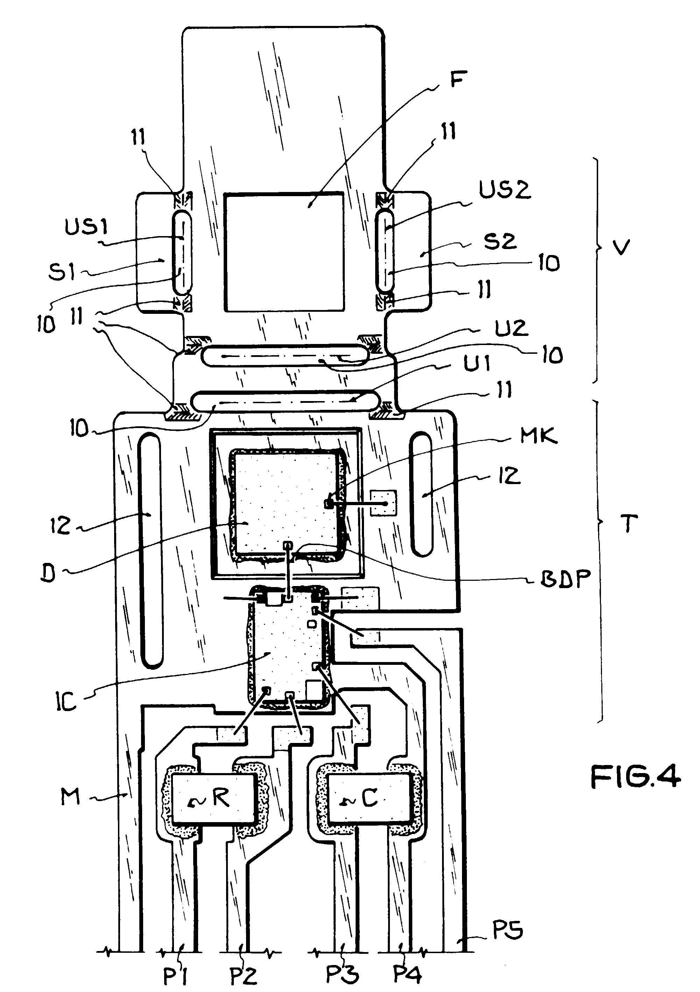

In der Halbleitertechnologie liegen Streifenanordnungen als lange Bänder vor, die von einer Rolle gewickelt werden. Fig. 1 zeigt nur eine einzige Anordnung mit einem Masse-Streifenteil M und einem Streifenteil P, über das ein vom Massepotential unterschiedliches Potential zugeführt werden kann. Das Masse-Streifenteil verfügt über einen Trägerabschnitt T und einen Verlängerungsabschnitt V. Im Ausführungsbeispiel der Fig. 1 und 2 ist ein Halbleiterbauteil HL mit Hilfe eines elektrisch leitenden Klebers auf den Trägerabschnitt aufgeklebt, wodurch die Rückseite des Halbleiterbauteils HL mit Masse verbindbar ist. Eine Kontaktfläche auf der Vorderseite des Halbleiterbauteils HL ist durch einen Bonddraht BD mit dem zweiten Streifenteil P verbunden. Das Halbleiterbauteil HL ist ein beliebiges Bauteil, mit Ausnahme von Detektorbauteilen, das gegen elektromagnetische Strahlung abzuschirmen ist. Detektorbauteile sind beim Ausführungsbeispiel der Fig. 1 und 2 ausgeschlossen, da der Verlängerungsabschnitt V kein Fenster aufweist, durch das zu detektierende Strahlung eindringen könnte. Ist ein solches Fenster vorhanden, treten besondere Probleme auf, die weiter unten anhand der Fig. 3 und 4 besprochen werden.

Der Verlängerungsabschnitt V ist mit dem Trägerabschnitt T über zwei etwas voneinander beabstandete Umklappnähte U1 und U2 verbunden. Entlang der Linien dieser Umklappnähte ist das Masse-Streifenteil durch Einprägungen etwas geschwächt, damit der Verlängerungsabschnitt V leicht so umgeklappt werden kann, daß er das Halbleiterbauteil HL abdeckt, wie dies aus der Schnittdarstellung von Fig. 2 gut erkennbar ist. An dem dem Trägerabschnitt T abgewandten Ende des Verlängerungsabschnitts V ist noch ein Endabschnitt E vorhanden, der mit dem Verlängerungsabschnitt über eine Umklappnaht UE verbunden ist. Schließlich sind zu beiden Seiten des Verlängerungsabschnittes noch Seitenabschnitte S1 und S2 vorhanden, die mit dem Verlängerungsabschnitt über jeweils eine Umklappnaht US1 bzw. US2 verbunden sind. Wenn diese Abschnitte alle umgeklappt sind, wird das Halbleiterbauteil ganz von ihnen umschlossen, so daß es sich innerhalb des elektromagnetisch abschirmenden, an Masse anschließbaren Gehäuses befindet. Bei den Ausführungsbeispielen gemäß allen Figuren weist der Trägerabschnitt T noch eine Vertiefung auf, in der das Halbleiterbauteil HL sitzt, was zum Verbessern der Abschirmung beiträgt, insbesondere wenn, wie dies beim Ausführungsbeispiel gemäß den Fig. 3 und 4 der Fall ist, im Verlängerungsabschnitt V ein Fenster vorhanden ist, und die gut leitende Vorderseite des Halbleiterbauteils mit dem Masse-Streifenteil verbunden ist.

Die Halbleiterbaugruppe gemäß Fig. 2 wird wie folgt hergestellt. Zunächst wird eine Schicht des Klebers KL in die in den Trägerabschnitt T eingezogene Vertiefung eingebracht. Auf diese Kleberschicht wird das Halbleiterbauteil HL aufgesetzt, woraufhin der Bonddraht BD mit dem Halbleiterbauteil und dem zweiten Streifenteil P verbunden wird. Nun werden die zwei Seitenabschnitte S1 und S2 sowie der Endabschnitt E hochgeklappt, woraufhin der Verlängerungsabschnitt V so umgeklappt wird, daß er parallel zum Trägerabschnitt T liegt, wie in Fig. 2 dargestellt. Eine Mehrzahl derartig behandelter Streifenaufbauten wird dann vom Band mit den Streifenanordnungen abgetrennt, und die mehreren noch zusammenhängenden Streifenaufbauten werden jeder für sich in eine Form mit einer Vergußmasse eingetaucht, wodurch ein Verguß VG gebildet wird, wie er in Fig. 2 gestrichelt angedeutet ist. Alternativ kann das Kunstsoffgehäuse durch einen in der Halbleiterindustrie üblichen Mouldprozeß hergestellt werden. Die so gebildeten Halbleiterbaugruppen werden dann entlang den in Fig. 1 angedeuteten strichpunktierten Linien voneinander getrennt.

Das Ausführungsbeispiel der Fig. 3 und 4 unterscheidet sich von demjenigen der Fig. 1 und 2 insbesondere dadurch, daß das abzuschirmende Halbleiterbauteil ein Infrarotdetektor D ist und daß noch weitere elektrische Bauteile vorhanden sind, nämlich eine integrierte Schaltung IC, ein SMD-Widerstand R und ein SMD-Kondensator C. Beim Ausführungsbeispiel ist der Detektor eine Si-pin-Diode. Alle elektrischen und mechanischen Bauteile bilden zusammen in vergossenem Zustand (der Verguß ist nicht dargestellt) einen Fernsteuer-Empfangsmodul. Die Fig. 3 und 4 beziehen sich auf den Fertigungszustand gemäß Fig. 1, in dem der Verlängerungsabschnitt V noch nicht über den Trägerabschnitt T geklappt ist. Auch die Seitenabschnitte S1 und S2 sind noch nicht hochgeklappt. Durch Umklappen der genannten Teile wird ein Zustand erreicht, der dem in Fig. 2 dargestellten entspricht, der jedoch für den Fernsteuer-Empfangsmodul nicht gesondert dargestellt ist. Es sind mehrere Streifenteile P1 - P5 neben dem Masse-Streifenteil M vorhanden.

Damit der Detektor D bei umgeklapptem Verlängerungsabschnitt V Infrarotlicht empfangen kann, ist im Verlängerungsabschnitt ein Fenster F vorhanden, dessen Größe und Lage so gewählt ist, daß es bei umgeklapptem Verlängerungsabschnitt die Empfangsfläche des Detektors D offenläßt. Der Verlängerungsabschnitt V ist etwas schmaler als der Trägerabschnitt T, da die Halbleiterbauteile D und IC auf dem Trägerabschnitt T schmaler sind als der Trägerabschnitt T selbst. Elektromagnetisch abzuschirmen ist insbesondere der Detektor D, jedoch ist der Verlängerungsabschnitt V so lang ausgebildet, daß er auch noch den IC vollständig überdeckt, insbesondere aber den Bonddraht BDP (Fig. 4) überdeckt, der den das Detektorsignal ausgebenden Kontakt mit einem Kontakt auf dem IC verbindet. Dieser das Signal führende Kontakt kommt von der Rückseite des Detektors D her, was aus der Draufsicht der Fig. 3 und 4 nicht deutlich erkennbar ist. Diese Rückseite ist mit einem nicht leitenden Kleber mit dem Trägerteil T verbunden. Vorzugsweise weist der Detektor noch eine isolierende Rückseitenbeschichtung auf, z.B. eine SiO₂-Passivierung. Die Detektordiode ist mit solcher Polarität auf den Trägerteil T aufgeklebt, daß ihre hochdotierte und damit gut leitende Seite oben liegt. Diese ist mit Hilfe eines Massekontaktes MK und eines Drahtes mit dem Masse-Streifenteil, also Masse, verbunden, wodurch die Vorderseite des Detektors D gegen elektromagnetische Strahlung abgeschirmt wird. Von der Seite her erfolgt die Abschirmung durch die Wände der Vertiefung im Trägerabschnitt T, durch die umgeklappten Seitenabschnitte S1 und S2 sowie durch den zwischen den Umklapplinien U1 und U2 liegenden Teil des Verlängerungsabschnitts V.

Um ein sicheres Abknicken aller umzuklappenden Abschnitte entlang der gewünschten Linien zu erreichen, sind entlang all dieser Linie Ausschnitte 10 und Prägungen 11 vorhanden (Fig. 4). Diese Ausschnitte 10 und Prägungen 11 werden zugleich mit dem Stanzen der Streifenteile hergestellt. Dabei wird auch die Vertiefung im Trägerteil T gezogen, in die der Detektor D eingesetzt ist. Weitere Aussparungen 12 werden im Trägerteil T hergestellt, um zu gewährleisten, daß eine sichere Verzahnung mit der Vergußmasse stattfindet. Dann werden thermische Bewegungen wirkungsvoll auf das Trägerteil übertragen, wodurch sich dieses in etwa derselben Weise ausdehnt oder zusammenzieht wie die Vergußmasse, was zu geringerer Beanspruchung von Bondstellen führt, als wenn sich die Vergußmasse und die Streifenteile unabhängig voneinander bewegen. Abhängig von den zur Verfügung stehenden Platzverhältnissen können die Aussparungen 12 im Trägerabschnitt T so gelegt werden, daß die Seitenabschnitte S1 bzw. S2 am Verlängerungsabschnitt V beim Umklappen in diese Aussparungen eindringen können, um dadurch eine besonders wirkungsvolle elektromagnetische Abschirmung zu erzielen.

Als Material für den Verguß VG kann im Fall des Ausführungsbeispiels der Fig. 1 und 2 jedes beliebige Vergußmaterial Verwendung finden, während im Fall des Aufbaus gemäß den Fig. 3 und 4 ein solches benutzt werden muß, das im Infrarotbereich ab etwa 800 nm durchlässig ist. Zu diesem Zweck wird in eine eigentlich durchsichtige Epoxidmasse ein Farbstoff gemischt, wie er für Kantenfilter für diesen Zweck üblich ist. Die Vergußmasse wird so geformt, daß sie an der dem Fenster F benachbarten Seite eine Sammellinse aufweist, die Infrarotlicht auf die Empfangsfläche des Detektors D lenkt. Diese ist vorzugsweise als Zylinderlinse ausgebildet, um ein leichtes Entformen der vergossenen Halbleiterbaugruppe zu ermöglichen. Wird alternativ ein Mouldverfahren eingesetzt, kann mit gleichem Aufwand sowohl eine zylindrische als auch eine rotationssymmetrische Linse realisiert werden.

## Patentansprüche

1. Halbleiterbaugruppe mit Streifenaufbau mit
- einem mit Masse zu verbindenden Masse-Streifenteil (M) als einem von mindestens zwei Streifenteilen (M; P; P1 - P5);
- mindestens einem Halbleiterbauteil (HL; D, IC), das auf dem Masse-Streifenteil *in dessen mittleren Bereich* auf einem Trägerabschnitt (T) des Masse-Streifenteils befestigt ist;
- einem Verlängerungsabschnitt (V) , mit dem das Masse-Streifenteil über den Trägerabschnitt hinaus verlängert ist; und
- einem *den mittleren Bereich* der Streifenteile einschließenden Verguß (VG);
dadurch gekennzeichnet,
- daß der Verlängerungsabschnitt (V) gegenüber dem Trägerabschnitt so umgeklappt ist und eine solche Länge aufweist, daß er das Halbleiterbauteil überdeckt, um dieses elektromagnetisch abzuschirmen, und
- daß der umgeklappte Verlängerungsabschnitt vom Verguß eingeschlossen ist.

2. Halbleiterbauteil nach Anspruch 1, **dadurch gekennzeichnet**, daß die Breite des Verlängerungsabschnitts (V) an die Breite des zu überdeckenden Halbleiterbauteils (HL; D, IC) angepaßt ist.

3. Halbleiterbauteil nach einem der Ansprüche 1 oder 2, **dadurch gekennzeichnet**, daß zu jeder Seite des Verlängerungsabschnitts (V) jeweils ein Seitenabschnitt (S1, S2) vorhanden ist, welche Seitenabschnitte zum Trägerabschnitt hin umgeklappt sind, wodurch sie das Halbleiterbauteil seitlich abschirmen.

4. Halbleiterbauteil nach einem der Ansprüche 1 bis 3, **dadurch gekennzeichnet,** daß an dem dem Trägerabschnitt (T) abgewandten Ende des Verlängerungsabschnitts (V) ein Endabschnitt (E) vorhanden ist, der zum Trägerabschnitt hin umgeklappt ist.

5. Halbleiterbauteil nach einem der Ansprüche 1 bis 4, **dadurch gekennzeichnet,** daß in den Trägerabschnitt (T) eine Vertiefung eingezogen ist, in der das Halbleiterbauteil (D) angeordnet ist.

6. Halbleiterbaugruppe nach einem der Ansprüche 1 bis 5, **dadurch gekennzeichnet,** daß entlang mindestens einer Umklapplinie (U1, U2, US1, US2, UE) schwächende Prägungen (11) im Masse-Streifenteil (M) vorhanden sind.

7. Halbleiterbaugruppe nach einem der Ansprüche 1 bis 6, **dadurch gekennzeichnet,** daß entlang mindestens einer Umklapplinie (U1, U2, US1, US2, UE) schwächende Aussparungen (10) im Masse-Streifenteil (M) vorhanden sind.

8. Halbleiterbaugruppe nach einem der Ansprüche 1 bis 7, **dadurch gekennzeichnet,** daß ein Halbleiterbauteil ein Strahlungsdetektor (D) ist und daß der Verlängerungsabschnitt (V) einen Ausschnitt (F) in demjenigen Bereich aufweist, unter dem die Empfangsfläche des Detektors bei umgeklapptem Verlängerungsabschnitt liegt.

9. Halbleiterbaugruppe nach Anspruch 8, **dadurch gekennzeichnet,** daß der Detektor (D) elektrisch isoliert auf das Masse-Streifenteil (M) geklebt ist, seine Oberseiten-Halbleiterschicht gut leitend ist und diese mit dem Masse-Streifenteil verbunden ist.

10. Halbleiterbaugruppe nach einem der Ansprüche 8 oder 9, **dadurch gekennzeichnet,** daß sie ein Fernsteuer-Empfangsmodul ist, mit für sich bekannten Schaltungskomponenten (HL; D, IC, R, C), die auf Streifenteilen (M, P1 - P5) aufgebaut sind, wobei der Strahlungsdetektor (D) des Moduls in der genannten Weise abgeschirmt ist.

## Claims

1. Semiconductor module having a strip-line type of construction including,
- an earthing strip part (M) that is to be connected to earth and which is one of at least two strip parts (M; P; P1 - P5);
- at least one semiconductor device (HL; D, IC) which is mounted on the earthing strip part at its central region on a support section (T) of the earthing strip part:
- an extension section (V) with which the earthing strip part is extended beyond the support section; and
- potting (VG) that encloses the central region of the strip part;
characterised in that,
- the extension section (V) has such a length and is folded relative to the support section in such a way that it covers the semiconductor device in order to screen it electromagnetically and
- that the folded extension section is enclosed by the potting.

2. Semiconductor device in accordance with Claim 1, characterised in that, the width of the extension section (V) is adapted to the width of the semiconductor device (HL; D, IC) that is to be covered.

3. Semiconductor device in accordance with either of Claims 1 or 2, characterised in that, there is a respective side section (S1, S2) on each side of the extension section (V), these side sections (S1, S2) being folded towards the support section whereby the semiconductor device is screened from the side.

4. Semiconductor device in accordance with any of the Claims 1 to 3, characterised in that, an end section (E), which is folded towards the support section, is provided at the end of the extension section (V) remote from the support section (T).

5. Semiconductor device in accordance with any of the Claims 1 to 4, characterised in that, a recess, in which the semiconductor device (D) is disposed, is indented in the support section (T).

6. Semiconductor module in accordance with any of the Claims 1 to 5, characterised in that, weakening indents (11) are present along at least one of the fold lines (U1, U2, US1, US2, UE) in the earthing strip part (M).

7. Semiconductor module in accordance with any of the Claims 1 to 6, characterised in that, weakening recesses (10) are present along at least one of the fold lines (U1, U2, US1, US2, UE) in the earthing strip part (M).

8. Semiconductor module in accordance with any of the Claims 1 to 7, characterised in that, one semiconductor device is a radiation detector (D) and that the extension section (V) comprises a cut-out (F) in that region below which the receiving surface of the detector lies when the extension section is folded over.

9. Semiconductor module in accordance with Claim 8, characterised in that, the detector (D) is adhered in electrically insulating manner to the earthing strip part (M), the semiconductor layer on its upper side is a good conductor and it is connected to the earthing strip part.

10. Semiconductor module in accordance with either of the Claims 8 or 9, characterised in that, it is a remote control receiving module including known circuit components (HL; D, IC, R, C) which are mounted on the strip parts (M, P1 - P5) whereby the radiation detector (D) of the module is screened in the stated manner.

## Revendications

1. Assemblage à semi-conducteurs ayant une structure à rubans, comprenant
- une partie formant un ruban de masse (M) et qui constitue l'une d'au moins deux parties sous forme de rubans (M; P; P1 - P5);
- au moins un composant à semi-conducteurs (HL; D, IC) qui est fixé dans la partie centrale du ruban de masse sur un segment de support (T) de ce ruban;
- un segment de rallonge (V) par lequel le ruban de masse est prolongé au-delà du segment de support; et
- un enrobage (VG) renfermant la partie centrale des parties en forme de rubans;
caractérisé en ce
- que le segment de rallonge (V) est replié de telle manière par rapport au segment de support et possède une telle longueur qu'il recouvre le composant à semi-conducteurs de façon à blinder ce composant contre des rayonnements électromagnétiques, et
- que le segment de rallonge replié est enfermé par l'enrobage.

2. Assemblage à semi-conducteurs selon la revendication 1, caractérisé en ce que la largeur du segment de rallonge (V) est adaptée à la largeur du composant à semi-conducteurs (HL; D, IC) à recouvrir.

3. Assemblage à semi-conducteurs selon la revendication 1 ou 2, caractérisé en ce que le segment de rallonge (V) est flanqué, sur chacun de ses deux côtés latéraux, d'un segment latéral (S1, S2), les segments latéraux étant repliés vers le haut, en direction du segment de support, de manière qu'ils assurent le blindage du composant à semi-conducteurs sur les côtés.

4. Assemblage à semi-conducteurs selon une des revendications 1 à 3, caractérisé en ce que le segment de rallonge (V) porte, à son extrémité éloignée du segment de support (T), un segment terminal (E) qui est replié en direction du segment de support.

5. Assemblage à semi-conducteurs selon une des revendications 1 à 4, caractérisé en ce que le segment de support (T) est pourvu d'un creux embouti dans lequel est placé le composant à semi-conducteurs (D).

6. Assemblage à semi-conducteurs selon une des revendications 1 à 5, caractérisé en ce que des empreintes (11) d'affaiblissement sont formées dans le ruban de masse (M) le long d'au moins une ligne de pliage (U1, U2, US1, US2, UE).

7. Assemblage à semi-conducteurs selon une des revendications 1 à 6, caractérisé en ce que le ruban de masse (M) présente des évidements (10) d'affaiblissement le long d'au moins une ligne de pliage (U1, U2, US1, US2, UE).

8. Assemblage à semi-conducteurs selon une des revendications 1 à 7, caractérisé en ce qu'il comprend un composant à semi-conducteurs constituant un détecteur de rayonnement (D) et que le segment de rallonge (V) présente une découpe (F) dans la zone sous laquelle est située l'aire réceptrice du détecteur après repliage du segment de rallonge.

9. Assemblage à semi-conducteurs selon la revendication 8, caractérisé en ce que le détecteur (D) est collé sur le ruban de masse (M) à l'état électriquement isolé, sa couche semi-conductrice formant le côté supérieur étant bonne conductrice et reliée au ruban de masse.

10. Assemblage à semi-conducteurs selon la revendication 8 ou 9, caractérisé en ce qu'il constitue un module récepteur de télécommande comportant des composants (HL; D, IC, R, C) en eux-mêmes connus, qui sont formés pour être fixés sur des parties en forme de rubans (M, P1 - P5), le détecteur de rayonnement (D) du module étant blindé de la manière indiquée.
